# EUROPEAN PATENT APPLICATION

(11) **EP 1 223 470 A1**
(43) Date of publication of application: **17.07.2002**
(21) Application number: 00964679.5
(22) Date of filing: 04.10.2000
(51) Int. Cl.: G03F 7/40, H01L 21/027, G11B 5/31

(54) **METHOD FOR FORMING PATTERN**

(30) Priority: 05.10.1999 JP 28468299
(71) Applicant: Clariant International Ltd., 4132 Muttenz 1 (CH)
(72) Inventor: KANDA, Takashi, c/o Clariant(Japan)K.K., Ogasa-gun, Shizuoka 437-1496 (JP); TANAKA, Hatsuyuki, c/o Clariant(Japan)K.K., Ogasa-gun, Shizuoka 437-1496 (JP)
(74) Representative: Hütter, Klaus, Dr.
(86) International application number: JP0006940
(87) International publication number: WO0125854

(57) **Abstract**

In a method for effectively making finer space portions in a pattern such as line-and-space pattern, trench pattern or hole pattern by providing on a resist pattern 11 of 2 µm or more on a substrate 2 a coating layer 3 capable of being cross-linked in the presence of an acid, and then cross-linking the coating layer 3 adjacent to the resist with an acid diffused from the resist pattern to thicken the resist pattern, the deformation of the thickened pattern is prevented by irradiating the resist pattern 11 with visible light or UV rays of 150 to 450 nm in wavelength before and/or after the formation of the coating layer. The thus formed pattern may further be subjected to metal plating to produce, for example, devices such as magnetic heads with high fidelity to the designed pattern.

## Description

### Technical Field

This invention relates to a method for thickening lines of a resist pattern by providing, on a resist pattern formed, a coating layer capable of being cross-linked in the presence of an acid and causing cross-linking of the coating layer adjacent to the resist utilizing diffusion of the acid from the resist into said coating layer to thereby effectively reducing dimension of the space portions of, for example, a line-and-space pattern and, more particularly, it relates to a method for thickening a resist pattern by providing, on a thick film resist pattern used in the process of manufacturing magnetic heads, micromachines, etc., the coating layer capable of being cross-linked in the presence of an acid to thereby effectively make the pattern finer.

### Background Art

In the wide field including manufacture of semiconductor devices such as LSI, preparation of flat panel displays (FPD) such as liquid crystal displays (LCD), manufacture of circuit bases such as thermal heads and manufacture of magnetic heads, photolithographic technology has so far been employed to form fine elements or conduct fine processing. In the photolithographic technology, positive- or negative-working photoresists are commonly used for forming a resist pattern. Such positive- or negative-working photoresist is coated on a substrate and, after mask alignment, exposed through the mask and developed to form a resist pattern. The thus formed resist pattern is utilized, for example, as an etching resist in manufacturing semiconductor devices, FPD or circuit bases, or as a metal plating resist in manufacturing magnetic heads.

In recent years, finer wiring and space width have increasingly been required in processes for manufacturing semiconductor devices and the like with the increase in integration degree of the semiconductor devices and the like. In order to meet the requirement, various attempts have been made such as an attempt to use a radiation with a shorter wave-length to thereby realize finer resist patterns, to use a phase shift mask or the like to thereby form finer resist patterns, to develop a novel resist adapted for these techniques or to develop a novel process. However, the photolithographic technology utilizing the conventional exposure techniques has difficulty in forming a fine resist pattern exceeding the critical resolution of the wavelength of radiation used for exposure. On the other hand, an apparatus for exposing radiation with shorter wavelength or an apparatus using the phase-shifting mask are expensive.

As one approach for solving such problem, there has been proposed a method for forming a fine pattern, described in Japanese Unexamined Patent Publication Nos. H5-241348, H6-250379, H10-73927, etc., in which a conventionally known positive- or negative-working photoresist is used and, after conducting pattern formation according to the conventionally known pattern-formation method, a layer of a coating layer-forming material capable of being cross-linked with an acid is applied on the formed resist pattern, the material layer is cross-linked and hardened by utilizing diffusion of an acid from the resist pattern caused by heating to thereby make the material layer insoluble in a developing solution, then unhardened portions are removed by development to thereby thicken the resist pattern and, as a result, make finer the resist pattern by narrowing the space portion in the resist pattern, thus a fine resist pattern with fineness effectively below the limit of resolution of the exposure radiation wavelength being formed. This method has attracted attention as a useful method because it enables to effectively reduce dimension of space portions in a resist pattern without additional expensive investment in equipment such as an exposure apparatus for exposing with short wavelength radiation.

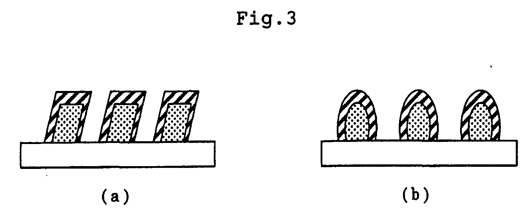

The above-described, conventionally proposed pattern-forming method has been developed as a method to be applied to an etching resist pattern not so thick in film thickness having a thickness of resist of, for example, not more than 1 µm such as an etching resist pattern for use in manufacturing semiconductor integrated circuits. In the case where thickness of the resist is not so thick, there arises no problem of deformation of a pattern after development even when the resist pattern is thickened by providing on the resist pattern a coating layer capable of being cross-linked in the presence of an acid and cross-linking and hardening the coating layer-forming material layer due to diffusion of an acid from the resist. However, it has been found that, when this method is applied to a resist pattern having a film thickness of 2 µm or more such as is used for manufacturing magnetic heads or micromachines, the pattern formed by removing unhardened portions after cross-linking the coating layer by development is inclined or deformed in a somewhat pressed state as shown in Fig. 3(a) or 3(b). The type of deformation of the pattern varies depending upon the position where the pattern portion is located in the patterned image. For example, deformation in a somewhat pressed state shown in Fig. 3 (b) is observed in the central portion of the wafer, i.e., central portion of the pattern image, whereas deformation of the resist pattern being pulled in one direction as shown in Fig. 3(a) is observed in the periphery of patterned image. When the resist pattern is deformed in such manner, devices such as magnetic heads can not be manufactured as designed, thus causing problems such as poor yield, poor efficiency of forming the coating layer and insufficient fineness.

An object of the present invention is to provide a method for making effectively finer a pattern such as line-and-space pattern, trench pattern or hole pattern than critical resolution of exposure wavelength by forming on a substrate a resist pattern of 2 µm or more in film thickness using photolithographic technology, coating on this resist pattern a coating layer-forming material capable of being cross-linked in the presence of an acid to form a coating layer capable of being cross-linked in the presence of an acid, and allowing the acid from the resist pattern to diffuse into the adjacent coating layer to cause cross-linking of the coating layer to thereby thicken the resist pattern, which prevents deformation of the pattern after being thickened and improve the efficiency of forming the cross-linked coating layer, thus generation of reject products inappropriate for manufacturing devices such as magnetic heads due to deformation of the resist pattern being prevented and a pattern with high fidelity to the design being effectively formed.

### Disclosure of the Invention

As a result of intensive investigations, the inventors have found that deformation of the resist pattern to be caused after developing the coating layer can be prevented and that cross-linking of the coating layer can be effectively conducted by adding a step of irradiating a resist pattern with visible light or ultraviolet rays of 150 to 450 nm in wavelength before and/or after the step of forming the coating layer capable of being cross-linked in the presence of an acid on the resist pattern of 2 µm or more in thickness having been formed on a substrate, thus having achieved the present invention based on the finding.

That is, the present invention relates to a method for forming a pattern by providing on a resist pattern of 2 µm in thickness a coating layer capable of being cross-linked in the presence of an acid and then cross-linking the coating layer with an acid diffused from the resist pattern to thereby thicken the resist pattern, wherein the resist pattern is irradiated with visible light or UV rays of 150 to 450 nm in wavelength before and/or after formation of the coating layer.

In addition, the present invention relates to a method of manufacturing a magnetic head by conducting a metal plating treatment after formation of the pattern in the above-described manner.

### Brief Description of the Drawing

Fig. 1 illustrates one embodiment forming a pattern thickened according to the present invention by irradiating with visible light or ultraviolet rays of 150 to 450 nm in wavelength after formation of a coating layer on a resist pattern.

Fig. 2 illustrates another embodiment forming a pattern thickened according to the present invention by irradiating a resist pattern with visible light or ultraviolet rays of 150 to 450 nm in wavelength, then forming a coating layer on the thus irradiated resist pattern.

Fig.3 illustrates examples of deformed pattern formed in a conventional manner.

### Detailed Description of the Invention

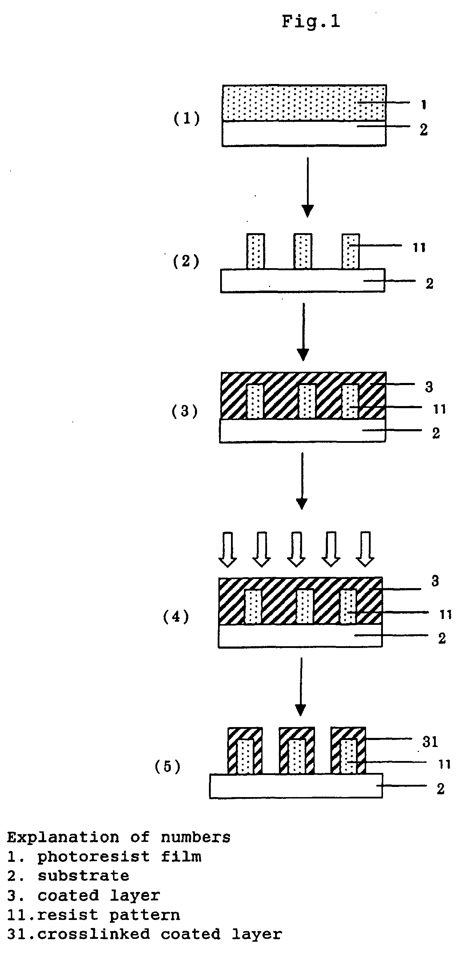

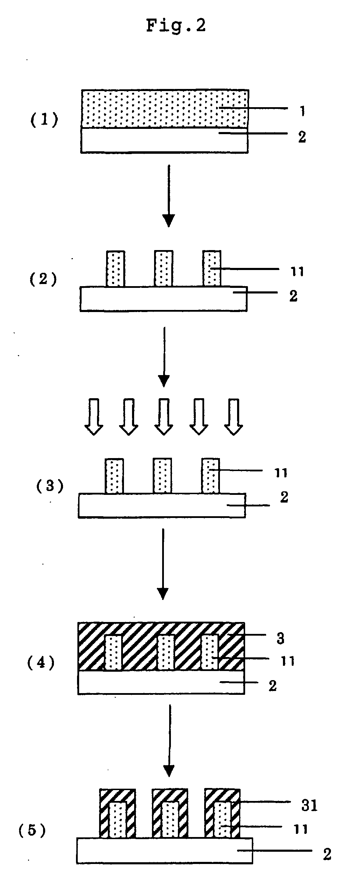

The present invention will be described in more detail below by reference to Figs. 1 and 2.

Fig. 1 shows one embodiment of the present invention of forming a pattern by forming a coating layer 3 on a resist pattern 11, then irradiating with visible light or ultraviolet rays of 150 to 450 nm in wavelength, and Fig. 2 shows another embodiment of the present invention of forming a pattern by irradiating the resist pattern 11 with visible light or ultraviolet rays of 150 to 450 nm in wavelength, then forming the coating layer 3 on the thus irradiated resist pattern.

Firstly, in Figs. 1 and 2, there is formed on a substrate 2 a resist pattern 11 of 2 µm or more in thickness capable of generating an acid upon being irradiated with visible light or ultraviolet rays ((2) in Fig. 1 and (2) in Fig. 2). This resist pattern 11 can be formed, for example, in the following manner utilizing the photolithographic method.

That is, firstly, a photoresist solution is coated on a substrate 2, then prebaked (for example, at a temperature of 70 - 140° C for about 1 minute) to form a photoresist layer 1 ((1) in Fig. 1 and (1) in Fig. 2). This photoresist layer 1 is patternwise exposed with UV rays such as g-line or i-line, deep-UV rays such as KrF excimer laser or ArF excimer laser, X-rays or electron beams and, optionally after post exposure baking (PEB; at a temperature of, for example, 50 - 140°C), developed and, if necessary, subjected to post development baking (at a temperature of, for example, 60 - 120°C) to form a resist pattern 11.

As the photoresist to be used for forming the above-described resist pattern 11, any of those which can form a resist pattern having a layer thickness of 2 µm or more may be used, with both positive- and negative-working of course being usable. As such photoresist, those are preferred which will generate an acid upon being irradiated with visible light or UV rays of 150 - 450 nm in wavelength, said generated acid acting to form a positive or negative resist pattern. As photoresists to be preferably used for forming the photoresist layer 1, there are illustrated, for example, positive-working resists containing an alkali-soluble resin such as novolak resin, hydroxystyrenic resin or acrylic resin and a quinonediazide compound and chemically amplified, positive- or negative-working resists which generate an acid by irradiation with light and form a resist pattern utilizing the catalytic action of the acid.

However, the photoresists to be used in the present invention may not necessarily be those which are composed of a material capable of themselves generating an acid upon exposure. In case where the resist material itself does not generate an acid upon exposure, it suffices, for example, to further add to the resist material a material that can generate an acid upon exposure.

In the present invention, a resist pattern is formed, and a coating layer-forming material is applied to the thus formed resist pattern 11 before or after irradiating the resist pattern with visible light or ultraviolet rays of 150 - 450 nm in wavelength, thus a coating layer 3 being formed ((3) in Fig. 1 and (4) in Fig.2). As the coating layer-forming materials to be used in the present invention, water-soluble resin compositions containing a water-soluble resin, a cross-linking agent and, if necessary, a surfactant and the like are illustrated as preferable ones. As the water-soluble resin to be used in the water-soluble resin compositions, there are illustrated homopolymers or copolymers of a vinyl monomer containing a hydrophilic group, such as polyvinyl alcohols (including partially saponified products of polyvinyl acetate), polyacrylic acid, polymethacrylic acid, poly(2-hydroxyethyl acrylate), poly(2-hydroxyethyl methacrylate), poly(4-hydroxybutyl acrylate), poly(4-hydroxybutyl methacrylate), poly(glycosyloxyethyl acrylate), poly(glycosyloxyethyl methacrylate), polyvinyl methyl ether, polyvinylpyrrolidone, polyethylene glycol, polyvinyl acetals (including partially acetalized ones), polyethyleneimine, polyethylene oxide, styrene-maleic anhydride copolymer, polyvinylamine, polyallylamine, etc.; oxazoline group-containing water-soluble resins; water-soluble melamine resins, water-soluble urea resins, alkyd resins, sulfonamides, or salts of these resins. These may be used independently or as a combination of two or more of them. Molecular weights of the water-soluble resins are preferably 1,000 - 10,000 in terms of weight average molecular weight, with 2,000 - 5,000 being more preferable.

As the cross-linking agents, there are illustrated as preferred examples water-soluble cross-linking agents such as melaminic low molecular derivatives, guanaminic low molecular derivatives, uric low molecular derivatives, glycol uril, alkoxyalkylated aminoresins, etc. Of these water-soluble cross-linking agents, the melaminic low molecular derivatives are exemplified by melamine, methoxymethylated melamine, ethoxymethylated melamine, propoxymethylated melamine, butoxymethylated melamine, hexamethylolmelamine, etc. The guanaminic low molecular derivatives are exemplified by acetoguanamine, benzoguanamine, methylated benzoguanamine, etc. Further, the uric low molecular derivatives are exemplified by urea, monomethylolurea, dimethylolurea, alkoxymethylene urea, N-alkoxymethylene urea, ethylene urea, ethylene urea carboxylic acid, etc.

On the other hand, the alkoxyalkylated aminoresins are exemplified by alkoxyalkylated melamine resins, alkoxyalkylated benzoguanamine resins, alkoxyalkylated urea resins, etc. Specifically, there are illustrated methoxymethylated melamine resin, ethoxyethylated melamine resin, propoxymethylated melamine resin, butoxymethylated melamine resin, ethoxymethylated benzoguanamine resin, methoxymethylated urea resin, ethoxymethylated urea resin, propoxymethylated urea resin, butoxymethylated urea resin, etc.

These water-soluble cross-linking agents may be used independently or in combination of two or more of them, and are compounded in an amount of 1 to 70 parts by weight, preferably 10 to 50 parts by weight, per 100 parts by weight of the water-soluble resin.

Further, as the surfactants, there are illustrated, for example, Fluorad manufactured by 3M Co., Nonipol manufactured by San-yo Kasei Co., Megafac manufactured by Dai-Nippon Ink & Chemicals, Inc., acetylene alcohols or acetylene glycols as represented by the following general formula (I), polyethoxylates of the acetylene alcohols, and polyethoxylates of the acetylene glycols. 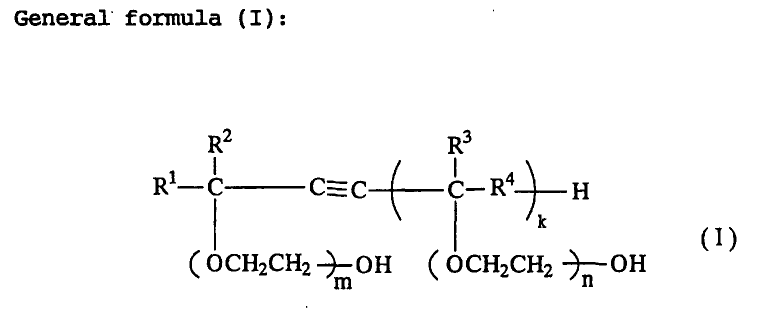 Wherein R¹ represents a straight or branched alkyl group containing 1 to 20 carbon atoms, R² and R³ each independently represent H or a straight or branched alkyl group containing 1 to 3 carbon atoms, R⁴ represents a straight or branched alkylene group containing 1 to 20 carbon atoms, k represents 0 or 1, and m and n each independently represent 0 or a positive number.

Of the surfactants, acetylene alcohols, acetylene glycols, polyethoxylates of the acetylene alcohols and polyethoxylates of the acetylene glycols are preferred in view of film-forming ability. Examples of the acetylene alcohols, acetylene glycols, polyethoxylates of the acetylene alcohols and polyethoxylates of the acetylene glycols include 3-methyl-1-butyn-3-ol, 3-methyl-1-pentyn-3-ol, 3,6-dimethyl-4-octyn-3,6-diol, 2,4,7,9-tetramethyl-5-decyn-4,7-diol, 3,5-dimethyl-1-hexyn-3-ol, 2,5-dimethyl-3-hexyn-2,5-diol, 2,5-dimethyl-2,5-hexanediol and polyethoxylates thereof, with tetramethyldecyndiols (e.g., 2,4,7,9-tetramethyl-5-decyn-4,7-diol) and the polyethoxylates thereof being particularly preferred. These surfactants may be used independently or in combination of two or more of them, and are compounded in an amount of usually 50 to 2,000 ppm, preferably 100 to 1,000 ppm, based on the water-soluble resin composition of the present invention.

As the solvent to be used in the water-soluble resin composition of the present invention, any of those may be used which can dissolve the components constituting the water-soluble resin composition and do not dissolve the resist pattern having already been formed on the substrate to be coated with the water-soluble resin composition. As the solvent, there are usually used those solvents which contain at least water, specifically, water, preferably pure water, and mixtures of water and a water-miscible organic solvent. As the water-miscible organic solvent to be used as a mixture with water, there are illustrated, for example, alcohols such as methyl alcohol, ethyl alcohol, isopropyl alcohol, etc.; ketones such as acetone, methyl ethyl ketone, 2-heptanone, cyclohexanone, etc.; esters such as methyl acetate, ethyl acetate, etc.; ethylene glycol monoalkyl ethers such as ethylene glycol monomethyl ether, ethylene glycol monoethyl ether, etc.; ethylene glycol monoalkyl ether acetates such as ethylene glycol monomethyl ether acetate, ethylene glycol monoethyl ether acetate, etc.; propylene glycol monoalkyl ethers such as propylene glycol monomethyl ether, propylene glycol monoethyl ether, etc.; propylene glycol monoalkyl ether acetates such as propylene glycol monomethyl ether acetate, propylene glycol monoethyl ether acetate, etc.; lactic esters such as methyl lactate, ethyl lactate, etc.; aromatic hydrocarbons such as toluene, xylene, etc.; amides such as N,N-dimethylacetamide, N-methylpyrrolidone, etc.; lactones such as γ-butyrolactone, etc.; polar solvents such as dimethylformamide, dimethylsulfoxide, cellosolve, methyl cellosolve, butyl cellosolve, cellosolve acetate, butyl carbitol, carbitol acetate, etc.; and the like. Preferable organic solvents include lower alcohols containing 1 to 4 carbons such as methyl alcohol, ethyl alcohol, isopropyl alcohol, etc., with isopropyl alcohol being particularly preferred. When using these organic solvents, they are to be mixed in an amount not to dissolve the resist pattern 11.

Application of the coating layer-forming material may be conducted in a proper manner conventionally employed for applying a photoresist, such as spin-coating method, spray-coating method, dip-coating method, roller-coating method, etc. The thus applied coating layer-forming material is, if necessary, prebaked to form a coating layer 3. Some of such coating layer-forming material are commercially available as, for example, AZ R200 (product of Clariant (Japan) K.K.; additionally "AZ" is a registered trademark; hereinafter the same) etc.

In the present invention, the thus formed resist pattern 11 is irradiated with visible light or UV rays of 150 to 450 nm in wavelength before or after forming the coating layer 3 on the resist pattern 11 ((4) in Fig. 1 and (3) in Fig. 2). In this irradiation treatment, irradiating conditions such as wavelength of the irradiating light, irradiating time, irradiating intensity, etc. may be selected depending upon the properties of the resist pattern to be irradiated, and are not particularly limited. As an irradiation apparatus, there may be used, for example, a Hg lamp, a g-line (wavelength: 436 nm) or i-line (wavelength: 365nm) irradiation apparatus, a KrF excimer laser-irradiation apparatus (wavelength: 248 nm), a KrCl excimer laser-irradiation apparatus (wavelength: 222 nm), a Xe excimer laser-irradiation apparatus (wavelength: 172 nm), a XeCl excimer laser-irradiation apparatus (wavelength: 308 nm), etc. If necessary, irradiation with visible light or UV rays may be conducted together with heating. The irradiation treatment is usually conducted by irradiating the whole pattern but, if necessary, only part of the pattern may be irradiated.

The above-described irradiation treatment with visible light or UV rays causes generation of an acid in the resist pattern. This acid generated by the irradiation treatment and, when an acid already exists in the resist pattern, the already-existing acid diffuse into a portion of the coating layer adjacent to the resist pattern to cause cross-linking and hardening of the adjacent portion of the coating layer, thus the coating layer being made insoluble for a developing solution. In order to accelerate diffusion of the acid, the resist pattern and the coating layer may be heat-treated (mixing-baked), if necessary. In conducting the mixing-bake, baking temperature and baking time may properly be determined depending upon the kind of resist used, kinds of materials forming the coating layer, desired thickness of cross-linked portion of the coating layer, etc. The mixing-bake is usually conducted at a temperature of about 85 to 150°C for a period of 60 to 120 seconds.

Further, the cross-linked coating layer is development treated with water, a mixture of water and a water-miscible organic solvent, an aqueous solution of alkali such as TMAH (tetramethylammonium hydroxide) or the like to dissolve away uncross-linked coating layer, leaving a non-deformed pattern covered with the cross-linked coating layer 31 ((5) in Fig. 5 and (5) in Fig. 2).

In coating a resist pattern with a cross-linked coating layer, mechanism how the thickened, non-deformed pattern is formed when the resist pattern is further irradiated with visible light or UV rays of 150 to 450 nm in wavelength is not fully clarified, but it may be surmised that generation of an acid in the resist pattern is accelerated by the irradiation with visible light or UV rays and, as a result, hardening of the resist pattern or the coating layer is accelerated.

### Best mode for practicing the Invention

The present invention will now be described more specifically by reference to Examples which, however, are not to be construed to limit the present invention in any way.

### Example 1

A positive-working photoresist, AZ P4210 (manufactured by Clariant (Japan) K.K.) was coated on a 6-inch silicon wafer using a spin coater (MK-V) made by Tokyo Electron Co., and prebaked on a hot plate at 100°C for 120 seconds to form a resist coat 1 of about 2.5 µm in thickness. Then, it was patternewise exposed (250 mJ/cm²) using an exposing apparatus (DSW 6400 made by GCA Co.; NA=0.42) emitting g-line (436 nm) (250 mJ/cm²), and spray puddle-developed at 23°C for 1 minute using an alkaline developer manufactured by Clariant (Japan) K.K. (AZ 400K developer; an inorganic alkaline developer solution) to obtain a line-and-space pattern.

On this resist pattern was applied AZ R200 (manufactured by Clariant (Japan) K.K.) as a coating layer-forming material using a spin coater (LT-1000) made by Lithotec Japan Co., followed by baking at 85°C for 70 seconds on a hot plate to form a 0.45-µm thick coating layer. Whole exposure was conducted over the coating layer using an exposure apparatus (DSW 6400 made by GCA Co.,; NA=0.42) with exposure wavelength of g-line (436 nm) .

Further, mixing-baking was conducted on a hot plate at 110°C for 90 seconds to allow the cross-linking reaction to proceed, then development processing was conducted at 23°C for 1 minute using pure water to remove uncross-linked layer, thus a layer of cross-linked water-soluble resin being formed on the line-and-space pattern. Baking treatment was further conducted for drying on a hot plate at 110°C for 120 seconds.

Observation of the thus formed pattern under a scanning electron microscope (SEM) revealed that the resist pattern suffered no deformation.

### Comparative Example 1

A pattern was formed in the same manner as in Example 1 except for conducting mixing-baking directly after formation of the coating layer with omitting the whole exposure by means of the g-line exposure apparatus. Observation of the formed pattern under SEM as in Example 1 revealed that the pattern portion at the central area of the wafer was deformed in a somewhat pressed state as shown in Fig. 3 (b) and that other portion than the central portion of the pattern was deformed as if being pulled in one direction as shown in Fig. 3 (a).

### Example 2

A pattern thickened by a cross-linked coating layer was formed in the same manner as in Example 1 except for forming the coating layer after conducting the whole exposure using the g-line exposure apparatus on the resist pattern in place of conducting the whole exposure using the g-line exposure apparatus after forming the coating layer on the resist pattern. Observation of the formed pattern under SEM as in Example 1 revealed that no deformation of the pattern was made as in Example 1.

### Example 3

A substrate having thereon the thickened pattern obtained in Example 1 was subjected to a metal plating treatment to form a metal plating layer having the same width and the same shape as designed.

### Advantages of the Invention

As is apparent from the descriptions hereinbefore, deformation of a resist pattern can be prevented, cross-linking efficiency is improved, and devices such as magnetic heads can be manufactured with high fidelity to designed pattern, thus yield of products and production efficiency being improved, by the method of the present invention of providing, on a resist pattern having been formed in a conventional manner and having a thickness of 2 µm or more, a coating layer and causing cross-linking and hardening of the coating layer to thicken the resist pattern to thereby effectively make finer a line-and-space pattern, trench pattern or hole pattern, wherein irradiation with visible light or ultraviolet rays of 150 to 450 nm in wavelength was conducted after the step of forming a resist pattern and before and/or after the step of forming a coating layer on the resist pattern.

## Claims

1. A method for forming a pattern which comprises forming on a resist pattern of 2 µm or more in thickness a coating layer capable of being cross-linked in the presence of an acid and then cross-linking the coating layer with the acid diffused from the resist pattern to thicken the resist pattern, wherein the resist pattern is irradiated with visible light or UV rays of 150 to 450 nm in wavelength before and/or after the formation of the coating layer.

2. A method of producing a magnetic head, wherein the pattern formed according to the method described in claim 1 is further subjected to metal-plating treatment.
